Europäisches Patentamt

European Patent Office

Office européen des brevets

(19)

(11) Publication number: **0 495 991 A1**

## EUROPEAN PATENT APPLICATION
### published in accordance with Art. 158(3) EPC

(21) Application number: **91913670.5**

(22) Date of filing: **06.08.91**

(86) International application number:
**PCT/JP91/01050**

(87) International publication number:
**WO 92/02955 (20.02.92 92/05)**

(51) Int. Cl.⁵: **H01L 27/115**

(30) Priority: **07.08.90 JP 208968/90**

(43) Date of publication of application:
**29.07.92 Bulletin 92/31**

(84) Designated Contracting States:
**DE FR GB IT NL**

(71) Applicant: **SEIKO EPSON CORPORATION**
**4-1, Nishishinjuku 2-chome**
**Shinjuku-ku Tokyo 163(JP)**

(72) Inventor: **TAKENAKA, Kazuhiro, 3-5, Owa**
**3-chome**
**Suwa-shi**
**Nagano-ken 392(JP)**

(74) Representative: **Bosotti, Luciano et al**
**c/o Jacobacci-Casetta & Perani S.p.A. Via**
**Alfieri, 17**
**I-10121 Torino(IT)**

(54) **SEMICONDUCTOR DEVICE.**

(57) A structure of a ferroelectric capacitor (C) is provided on a source region (24) between a gate electrode (23) and a local oxide film (26). The capacitor (C) has a ferroelectric film (29) sandwiched between an upper electrode (32) and a lower electrode (28), and a film (31) for preventing oxygen from diffusing between the lower electrode (28) and a first interlayer insulating film (30). The film (31) is made of SiN or SiON. Even if for the purpose of transforming the crystallinity of the ferroelectric film (29) it is subjected to an oxygen annealing treatment, oxygen is blocked by the film (31). Therefore, the variation of the threshold voltage and the increase of the leakage current of a transistor scarcely occur. Thereby, the degree of freedom of setting the condition of forming ferroelectric film increases, and a ferroelectric memory of high performance and of large scale integration can be formed.

## FIELD OF THE INVENTION

The present invention relates to a semiconductor device provided with ferroelectric materials such as a ferroelectric capacitor etc. which can be applied to a nonvolatile memory or the like.

## BACKGROUND OF THE INVENTION

A nonvolatile memory using ferroelectric materials which can reverse its polarization according to polarities of voltage applied thereto has, in principle, the same writing and reading times. Further, at a quiescent or non-operative state (at backup time) the afore-mentioned nonvolatile memory keeps polarization (residual polarization), even if no voltage is applied thereto. Therefore, it has been regarded as an ideal nonvolatile memory.

Conventionally, there has been proposed various kinds of semiconductor nonvolatile memories using ferroelectric capacitors such as disclosed in the specification of US Patent No. 4,149,302 that has a construction in which on a silicon (Si) substrate ferroelectric capacitors are integrated, also such as disclosed in the specification of US Patent No. 3,832,700 that has a construction which is composed by disposing ferroelectric films on the gate electrode of a MIS-type transistor.

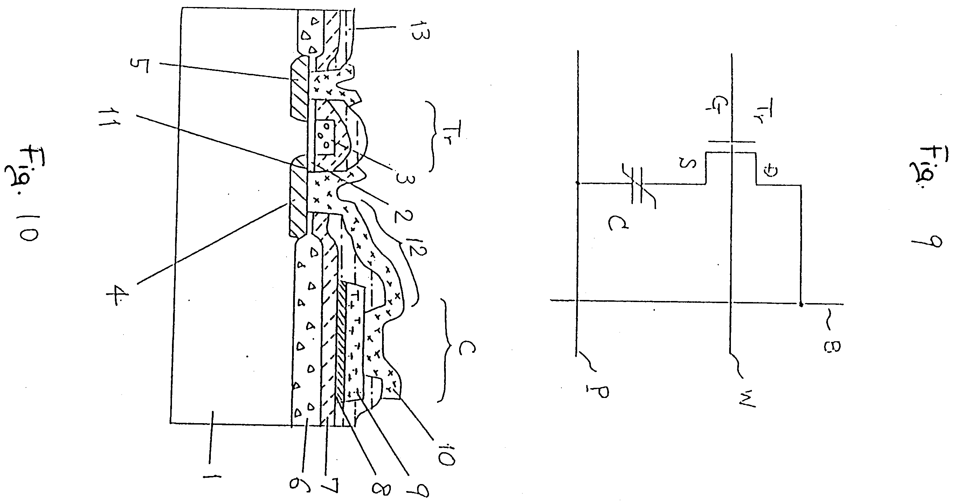

A nonvolatile memory cell comprises, in general, as shown in Fig. 9, an N-type transistor Tr which has a gate electrode G connected to a word line W, a drain electrode D connected to a bit line B and a source electrode S connected to one electrode of a ferroelectric capacitor C, the other electrode of the ferroelectric capacitor C being connected to a plate line P.

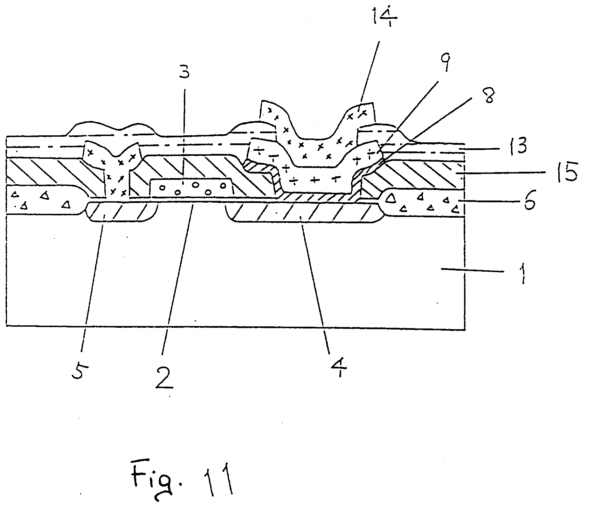

As a practical semiconductor construction of such a memory cell, recently, such a semiconductor construction as shown in Fig. 10 has been proposed. The semiconductor construction shown in Fig. 10 comprises an N-type MOS transistor Tr which has a gate electrode 3 of a polysilicon (polycrystal silicon) formed through a gate oxide film 2 on a P-type silicon substrate 1, source and drain zones 4 and 5 of an N-type high concentration formed in the silicon substrate 1 by using a self-aligning diffusion technique, and a ferroelectric capacitor C formed on an interlayer insulation film 7 such as phosphoric glass etc. disposed between layers on a local oxide film (LOCOS) 6 for isolating elements, wherein the ferroelectric capacitor C on the interlayer insulation film 7 is composed of a lower electrode 8 made of such as platinum (Pt) etc., a ferroelectric film 9 such as PZT etc. and an upper electrode 10 of Aluminum (Al) stacked in that order. The source zone which is a high concentration diffusion region and the upper electrode 10 are connected to each other with a wiring 12 made of Al through a contact hole 11. The reference number 13 indicates a second interlayer insulation film made of phosphoric glass and the like.

The ferroelectric substance is made of an oxide, so that to improve crystallization thereof it is necessary to carry out oxygen annealing of the ferroelectric film 9 after it has been formed. Oxygen annealing improves crystallization of the high dielectric film. However, in the transistor part oxygen diffuses down to the interface of silicon to generate an interface state which results in varying the threshold voltage and/or increasing leak current in the source and the drain diffusion layers.

In addition, as shown in Fig. 10, in the construction of the ferroelectric capacitor C formed on the interlayer insulation film 7 on the local oxide film 6, the ferroelectric capacitor C is formed by effectively utilizing a space on the local oxide film 6, but the length between the source zone 11 and the upper electrode 10 and that of the wiring 12 from the upper electrode 10 to a plate line P are too prolix, which results in the increasing of an area to be occupied by the memory cell. Then, the present inventor has manufactured for trial a memory cell structure in which, as shown in Fig. 11, the ferroelectric film 9 is directly accumulated over the source zone 4. In this structure an upper electrode wiring 14 of polysilicon is formed on the ferroelectric film 9, and through a contact hole being opened in an interlayer insulation film 15 of phosphoric glass and the like, the lower electrode 8 made of material such as Pt is formed. However, even in such a structure, after the ferroelectric film 9 has been formed, it is necessary to carry out oxygen annealing of the film to improve crystallization of the film thereby enhancing relative dielectric constant Es. However, once the oxygen annealing was carried out, as mentioned the above, there occurred a change of the threshold voltage of the transistor and/or the increase of leak current. Thus, normal operation of the memory could not be expected.

With the afore-mentioned reasons, in the structures shown in Figs. 10 and 11, there still remains a problem that the function of the ferroelectric substance cannot be compatible with that of the transistor.

In view of the aforesaid problems of the conventional devices, the object of the present invention is to provide a semiconductor device comprising a ferroelectric substance having a structure in which the function of a transistor can be achieved without impeding the function of a nonvolatile memory having a ferroelectric substance therein.

## DISCLOSURE OF THE INVENTION

The present invention is, fundamentally, to provide a formation or structure having a ferroelectric substance on the principal surface or on the inside of a semiconductor body or semiconductor substrate. A typical semiconductor substrate is silicon. Also, the present invention is applicable to semiconductor bodies which have a bonding property with oxygen such as compound semiconductors of GaAs, for example. Regions of the structure where the ferroelectric substance is formed may be intrinsic semiconductor regions and/or N-type or P-type impurity diffusion regions or zones. As the impurity diffusion zone, a source zone or a drain zone of a MIS-type transistor and diffusion zones for the three electrodes of a bipolar transistor are typical examples. The ferroelectric substance formation can be achieved not only over an active region of an active element, but also over each of the regions of a passive element such as, for example, a diffusion resistant layer, a stopper region etc. Of course, it can be realized to form a structure of a ferroelectric capacitor in a stacking manner over an isolation region and over the diffusion region, and it is also possible to realize the structure having the ferroelectric substance even in a trench. That is, the present invention takes measures to adopt a construction in which an oxygen-diffusion preventing film is held between a semiconductor body and an electrode of a ferroelectric substance. In other words, the present invention adopts a laminated-layers structure in which a semiconductor body, an oxygen-diffusion preventing film, an electrode and a ferroelectric film are sequentially laminated. As a ferroelectric substance, $PbTiO_3$, PZT ($PbTiO_3$, $PbZrO_3$) or PLZT (La, $PbTiO_3$, $PbZrO_3$) etc. are used, and these kinds of high ferroelectric films are formed by, for example, a sputtering process, and then, for improving dielectric constant etc., it is necessary to carry out an oxygen annealing process. The electrode of the ferroelectric film may be formed of, for example Pt or Pd, and further, it is preferable to use Pt which has a lattice constant being near that of a crystal of the ferroelectric substance.

The oxygen-diffusion preventing film is a film that comprises as the principal component silicon nitride such as, for example, SiN, SiON, etc. A film having as the principal component silicon oxide may be interposed between the oxygen-diffusion preventing film and the electrode. In this silicon oxide film impurities such as phosphor, boron, gallium, arsenic, etc. may be included. The construction in which the oxygen-diffusion preventing film is interposed between the semiconductor body and the electrode prevents oxygen from being diffused to the interface of the semiconductor body during the afore-mentioned oxygen annealing process, and also prevents oxygen from being diffused to the silicon interface, to thereby hinder the generation of variation of the threshold voltage and a leakage current. As a result of this, it can be attained that both functions of the ferroelectric substance and the transistor are compatible, so that a ferroelectric memory can be realized.

In addition, according to the second structure of the present invention, the afore-mentioned oxygen-diffusion preventing film is contacted with the silicon interface at a connecting hole position for connecting the film to the diffusion layers formed at the semiconductor substrate. The structure aims to prevent oxygen from being diffused from the connecting hole position.

According to the construction of the semiconductor device of the present invention, it adopts a stacked structure in which a semiconductor body, an oxygen-diffusion preventing film, an electrode and a ferroelectric film are sequentially formed. The oxygen-diffusion preventing film prevents diffusion of oxygen into a silicon interface and, accordingly, the diffusion of oxygen into the interface of the semiconductor is prevented during the oxygen annealing process. Thus, evil effect of the annealing process on a transistor can be prevented.

BRIEF DESCRIPTION OF THE DRAWINGS

Fig. 1 is a main sectional view of a first embodiment of the present invention;
Fig. 2 is a main sectional view of a second embodiment of the present invention;
Fig. 3 is a main sectional view of a third embodiment which is a modification of the present invention;
Fig. 4 is a main sectional view of an embodiment which is another modification of the present invention;
Fig. 5 is a main sectional view of a fifth embodiment of the second means of the present invention;
Fig. 6 is a main sectional view of a sixth embodiment of the present invention;
Fig. 7 is a main sectional view of a seventh embodiment of the present invention;
Fig. 8 is a main sectional view of a eighth embodiment of the second structure of the present invention;
Fig. 9 is a circuit view showing a nonvolatile memory;
Fig. 10 is a main sectional view showing a semiconductor device comprising a ferroelectric capacitor relating to the conventional art; and
Fig. 11 is a main sectional view showing another semiconductor device comprising a ferroelectric capacitor according to the conventional art.

THE PREFERRED FORMS FOR CARRYING OUT THE INVENTION

Referring to the accompanying drawings, hereinafter, the present invention will be described in detail.

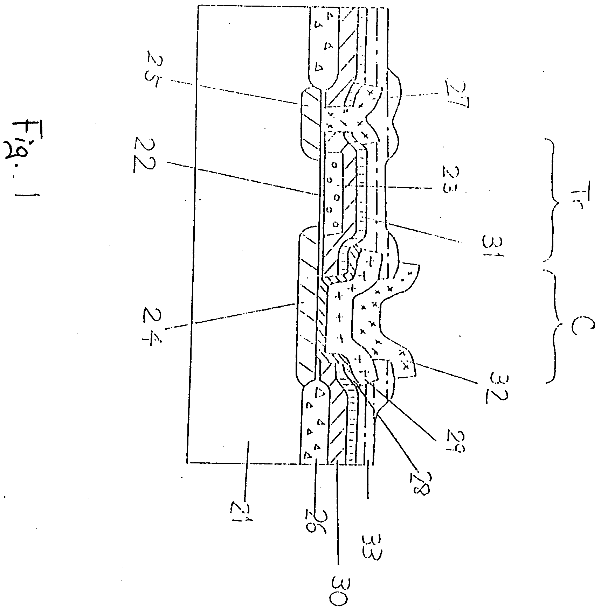

Fig. 1 is a main sectional view showing a semiconductor device provided with a ferroelectric capacitor relating to the first embodiment of the present invention.

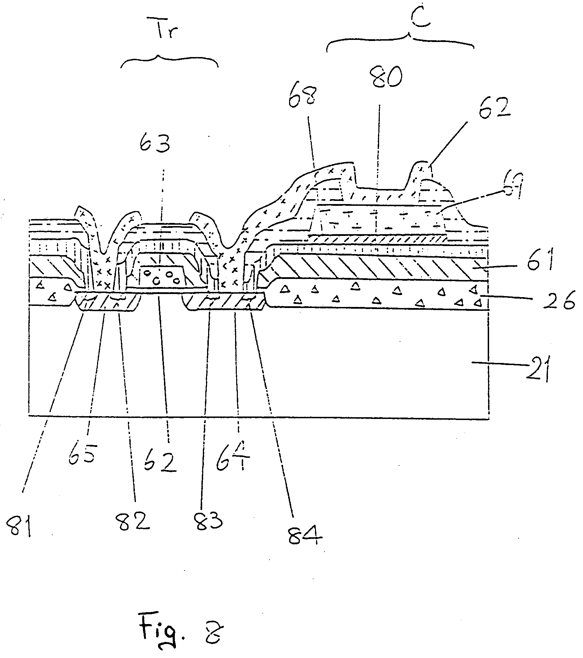

The present semiconductor device is a non-volatile memory, and its equivalent circuit has a memory cell as shown in Fig. 8. In this embodiment, a P-type silicon substrate 21 made of a wafer having specific resistance 20 ohm.cm is used. On the substrate structures of a N-type MOS transistor Tr and a high ferroelectric capacitor C are formed. As is well known, a semiconductor structure of the N-type MOS transistor Tr comprises a gate electrode 23 made of phosphor-doped polysilicon on a gate insulation film (silicon oxide film) 22 formed on the silicon substrate 21, a source region 24 and a drain region 25 which are N-type diffusion regions of a high impurity concentration. The diffusion regions are formed in the substrate by an ion implantation of phosphor under a condition of 80 KV and $5 \times 10^{15}/cm^2$ while using the gate electrode 23 as a mask with a self-aligning manner. To the drain region 25 a wiring electrode 27 of Al formed by depositing method or sputtering method through a contact hole is connected. The reference number 26 indicates a local oxide film (LOCOS) for isolation and has a thickness of about 600 nm. Further, the reference number 30 indicates a first interlayer insulation film and 33 a second interlayer insulation film. For example, both of them are made of phosphoric glass having a thickness of about 400 nm formed by a CVD technique.

In this embodiment, the structure of the ferroelectric capacitor C is provided on the source region 24 between the gate electrode 23 and the local oxide film 26 is provided. The capacitor C may be called ferroelectric substance forming structure. This structure has a basic ferroelectric film 29, and an upper electrode 32 and a lower electrode 28, both being electrode layers which hold the basic ferroelectric film 29 between them, and the structure also has an oxygen-diffusion preventing film 31 situated between areas except for a part of the lower electrode 28 which contacts with the source diffusion layer and the first interlayer insulation film 30. The ferroelectric film 29 is formed by using a material such as $PbTiO_3$, PZT ($PbTiO_3$, $PbZrO_3$), PLZT (La, $PbTiO_3$, $PbZrO_3$) or the like. The film is formed to a thickness of about 500 nm by a sputtering method. The upper electrode is formed, as an example, by vapor deposition or sputtering of Aluminum (Al) having a low specific resistance. Platinum (Pt) or Palladium (Pd) is used for forming the lower electrode 28. The electrode is formed, for example, by a sputtering method to a thickness of 300 nm. In the case of using Platinum (Pt) for making the lower electrode 28, since it has a lattice constant close to that of $PbTiO_3$, PZT or PLZT used for ferroelectric film 29. Therefore, when the ferroelectric film 29 is subjected to an oxygen annealing process, its crystallinity is simultaneously improved, and thus good electric conductivity can be obtained. The oxygen-diffusion preventing film 31 interposed between the first interlayer insulation film 30 and the lower electrode 28 is a film such as a SiN film, SiON film, etc. having silicon nitride as a principal ingredient, and is, as one example, formed to a thickness of 50 nm by a gas phase growth method.

A method for forming a semiconductor device including such a ferroelectric capacitor comprises the steps of forming the oxygen-diffusion preventing film 31 by using a vapor phase growing process after forming the first interlayer insulation film 30 which covers over the source region 24, forming a contact hole through the first interlayer insulation film 30 and the oxygen-diffusion preventing film 31, laminating or stacking each of the lower electrode 28 and the ferroelectric film 29 by using a sputtering process, respectively, forming predetermined patterns of the electrode and the film by the conventional photolithography technique, and etching the lower electrode 28 and the ferroelectric film 29 by using, for example, the conventional ion milling technique. Then, the whole surface of the obtained structure is covered with the second interlayer insulation film 28, and thereafter the upper electrode 32, its wiring (the plate line) and the drain electrode wiring 27 are formed by using the conventional photo-etching technique.

As described above, upon the source region 24 the ferroelectric capacitor C is stacked via the conductive, reactiob-preventing layer 31 acting as a reaction preventing layer. Accordingly, an occupied area of the wiring place between the source region 24 and the lower electrode 28 can be effectively saved, so that a reduction of an area of a cell has been successfully realized. In addition, since an oxygen-diffusion preventing film is formed on the transistor part, a ferroelectric memory free from the variation of the threshold voltage and the increase of leaking current can be formed.

In the afore-mentioned manufacturing processes, the ferroelectric film 29 is formed, and then subjected to a heat treatment (oxygen annealing process) in an atmosphere including oxygen. This treatment is carried out for improving crystallinity of the ferroelectric film 29 to enhance the specific dielectric constant Es thereof, for example, up to a value more than 1000.

In a non-volatile memory having a conventional ferroelectric capacitor structure with no oxygen-diffusion preventing film 31, as shown in Fig. 9, the number of times of information rewriting was 10 x $10^5$ since no oxygen annealing process could be carried out at high temperatures. However, according to the present embodiment, a SiN film is used as the oxygen-diffusion preventing film and thus more than a 500 °C oxygen annealing could be done, so that the number of times of information rewriting reached up to 10 x $10^9$. The specific dielectric constant Es of the ferroelectric film becomes a value of around 1500.

As described above, the advantages of constructing the ferroelectric capacitor C upon the source region 24 as a vertical structure reside not only in reducing the area occupied by a cell, but also reducing one of the contact portions with the electrode (contact resistant portions) in comparison with the conventional structure as shown in Fig. 10. This could be achieved substantially by excluding the wiring 12 shown in Fig. 10. That is, it results in reducing the time for writing and reading information. In addition, as can be clearly understood by comparing Fig. 1 and Fig. 10, the upper electrode 10 in Fig. 10 corresponds topologically to the lower electrode 28 of the present invention, and the lower electrode 8 in Fig. 10 corresponds topologically to the upper electrode 32 of the present invention. In the present invention it is preferable to select Pt as a material for the lower electrode 28, while Pt has larger specific resistance compared with that of Al. However, the lower electrode 28 of the present invention is thin in film thickness and has a wider contacting area than that of the contact hole. Accordingly, resistance values between the source region 24 and the ferroelectric capacitor C are substantially no problem. It is also possible to form the upper electrode 32 serving as the plate line P and its wiring of Aluminum. This is because of the plate line P being able to form over the ferroelectric film 29. For this reason, fluctuation of the plate voltage in each of cells is improved remarkably in comparison with the conventional cells. Further, in a conventional art, a ferroelectric capacitor C is stacked vertically over a LOCOS film, and there has been a problem with step coverage. However, in the present invention, since the ferroelectric capacitor is formed at both sides of the gate electrode 23, step coverage can be improved.

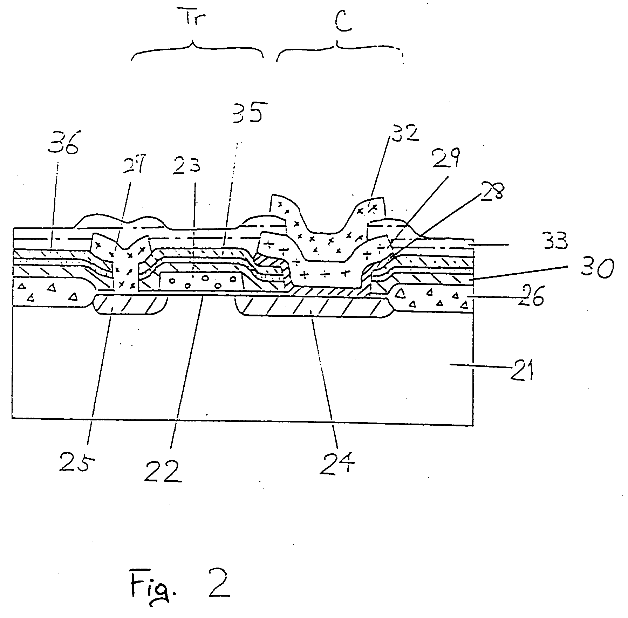

Fig. 2 is a sectional view showing a principal part of a semiconductor device provided with a ferroelectric capacitor relating to the second embodiment of the present invention. Please note in this figure that the same reference numeral is given to each of the same parts shown in Fig. 1, and the explanation for each of them is abbreviated. Also, in this embodiment the ferroelectric capacitor C is stacked over the source region 24. In this embodiment an oxygen-diffusion preventing film 35 is interposed between the first interlayer insulation film 30 and a third interlayer insulation film 36 made of such as phosphor glass etc. The primary object of this third interlayer insulation film 36 lies in relieving stress between the lower electrode 28 and the oxygen-diffusion preventing film 35, and improving adhesion therebetween. The third interlayer insulation film 36 may be formed by silicon oxide not including any impurity. However, it may be preferably formed by phosphoric glass in which the content of phosphor having a lower softening temperature is more than 1 %, boronic glass having more than 1 % boron or silicon oxide including other impurities. The reason why the above-mentioned can be achieved lies in relieving stress by softening it in an annealing process. In the second embodiment, for example, the first interlayer insulation film was made to a thickness of 200 nm, that of the oxygen-diffusion preventing film was to 50 nm, and the thickness of the third interlayer insulation film was formed to 200 nm. Both in the first and second embodiments, even if a thickness other than those herein described, there is no problem.

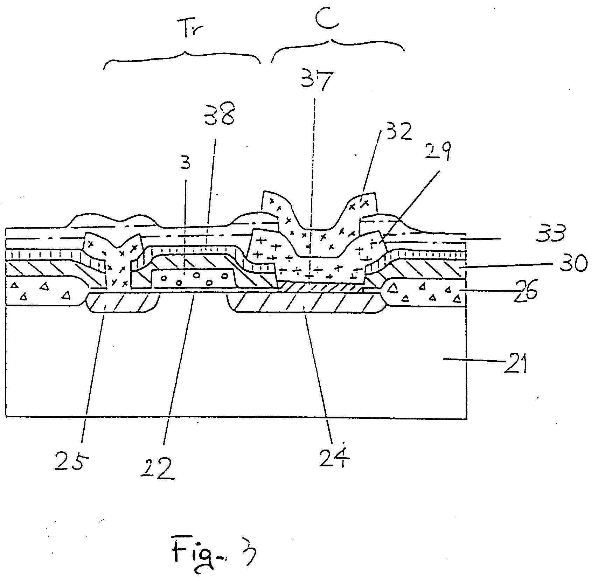

Fig. 3 is a main sectional view showing a semiconductor device provided with the ferroelectric capacitor having to do with the third embodiment which is a modification of the present invention. The third embodiment is an example of an applied form of the first embodiment, and in the third embodiment a lower electrode 37 is PtSi, TiSi, etc., formed over only the contact hole bored over the source diffusion layer 4. In this case an oxygen-diffusion preventing film 29 and the first interlayer insulation film 30.

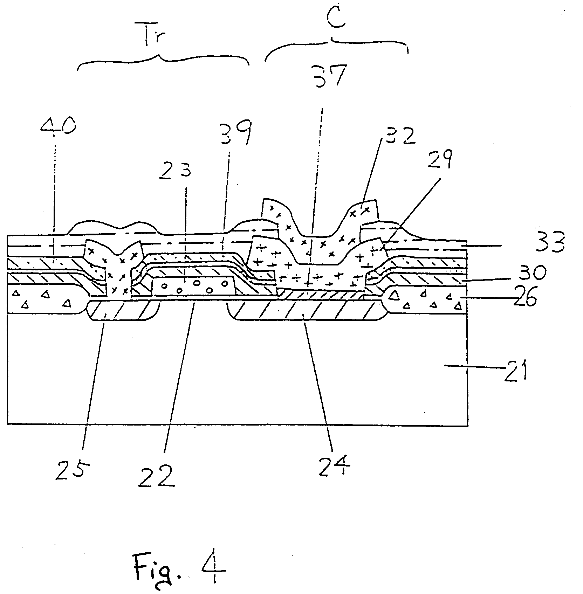

Fig. 4 is a main sectional view showing a semiconductor device having a ferroelectric capacitor relating to a fourth embodiment which is another modification of the present invention. The fourth embodiment is a modification of the second embodiment in which the lower electrode 37 is PtSi, TiSi, etc., formed only over the contact hole bored over the source diffusion layer 4. In this case an oxygen-diffusion preventing film 39 is formed on the first interlayer insulation film 30, and a third interlayer insulation film 40 is formed between the ferroelectric film 29 and the oxygen-diffusion preventing film 39. This construction is applicable to the present invention.

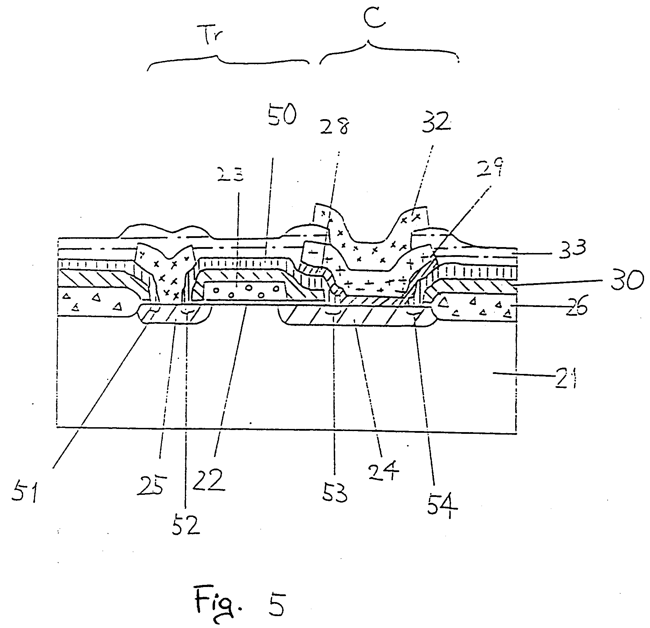

Fig. 5 is a main sectional view showing a semiconductor device with the ferroelectric capacitor which relates to a modification of the first embodiment to which the second structure of the present invention is applied. Even in this embodiment the ferroelectric capacitor C is also formed on the source region 24 in a stacked manner. In this embodiment an oxygen-diffusion preventing film 50 is, same as that of the first embodiment, held between the first interlayer insulation film 30 and the lower electrode 28. The subject of the second structure of the present invention lies in that the oxygen-diffusion preventing film 50 is contacted with the drain diffusion layer 25 and the source diffusion layer 24 at portions 51, 52, 53 and 54 of the contact hole. By adopting such construction as described above, in the case of an oxygen annealing process, diffusion of oxygen from the contacting hole to the transistor parts is more completely prevented, so that the transistor properties, such as stability of threshold voltage and prevention of current leaking, can be extremely enhanced.

The embodiment shown in Fig. 5 is one embodiment in which the second structure of the present invention is applied to the first embodiment, and it is needless to say that, of course, the second structure of the present invention can be applied to the second, third and fourth embodiments of the present invention.

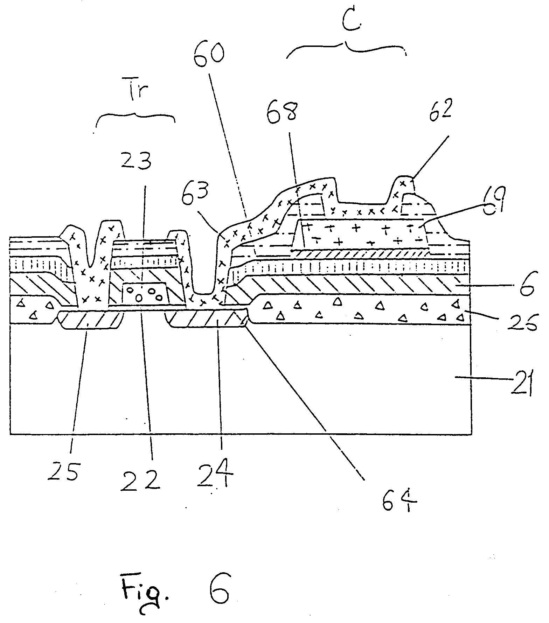

Fig. 6 is a main sectional view showing a semiconductor device having the ferroelectric capacitor relating to an embodiment to which the first structure of the present invention is applied to the construction of the conventional semiconductor device. Over the isolation region 26 there are sequentially formed a first interlayer insulation film 61, an oxygen-diffusion preventing film 60, a lower electrode 68 and a ferroelectric film 69 in a stacked manner. That is, the oxidation-preventing film 60 is held between the lower electrode 68 and the first interlayer insulation film 61. The upper electrode 62 is connected with the source diffusion layer by a wiring electrode 63. The first interlayer insulation film 61 is formed with a phosphoric glass of 300 nm in thickness, and the oxygen diffusion film 60 is formed with a SiN film of 50 nm in thickness. In the case where the present invention is applied to such conventional construction, if an oxygen annealing process is carried out for improving crystallinity of the ferroelectric film, oxygen diffusion to the transistor parts can be prevented, and a ferroelectric film, having excellent characteristics, and a transistor can be formed on the same substrate. In addition, as can be understood from its sectional structure, an opening of a contact hole 64 to the source diffusion layer 24 is made after a lower electrode 68 and a ferroelectric film 69, having been formed, so that the annealing process for improving crystallinity of the ferroelectric film 69 can be carried out before the contact hole is formed. That is, in a state that the transistor parts have been wholly coated by the oxygen-diffusion preventing film 60 the oxygen annealing process can be performed.

Accordingly, there is no need for paying attention to a negative influence on the transistor parts caused by the oxygen annealing process. Actually, an annealing process was carried out with the following conditions, that is, the lower electrode 68 Pt having a thickness of 30 nm is used, the ferroelectric film PZT having a thickness of 500 nm is used and oxygen annealing at temperature of 700 ° C results in a relative dielectric constant of 1850 and a value of residual polarity 13 micro.coulomb/square cm.

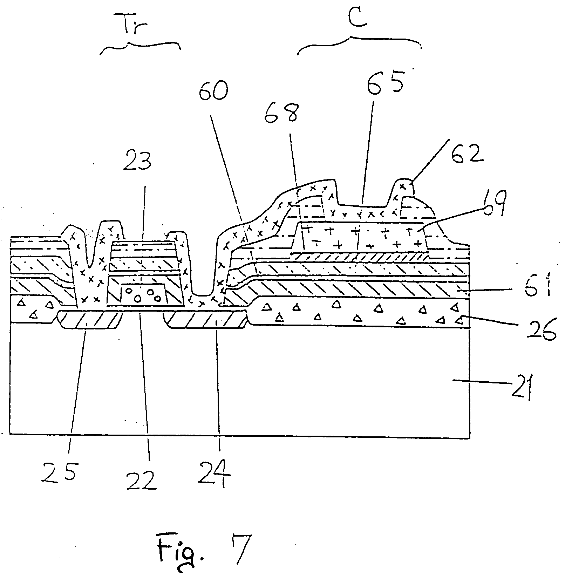

Fig. 7 shows a main sectional structure of a semiconductor provided with a ferroelectric capacitor relating to a seventh embodiment in which the first structure of the present invention is applied to the conventional construction. Over isolation region 26 the first interlayer insulation film 61, the oxygen-diffusion preventing film 60, the third interlayer insulation film 65 made of, for example, phosphoric glass, the lower electrode 68 and the ferroelectric film 69 are stacked. That is, the oxygen-diffusion preventing film 60 is held between the first interlayer insulation film 61 and the third interlayer insulation film 65, and the lower electrode 68 is formed over the third interlayer insulation film 65. The upper electrode 62 is connected with the source diffusion layer by the wiring electrode 63. The first interlayer insulation film 61 is formed with a phosphoric glass of the thickness of 300 nm, the oxygen-diffusion preventing film 60 is a SiN film of a thickness of 50 nm is formed and the third interlayer insulation film 65 is made with a phosphoric glass which includes phosphor of 2 % and has a thickness of 300 nm. The third interlayer insulation film 61 may be silicon oxide including no impurity, the same as the second embodiment of the present invention shown in Fig. 2. However, it is more preferable to select phosphoric glass which includes phosphor more than 1 % which has a lower softening temperature, boronic glass containing phosphor and boron more than 1 % and silicon oxide including other impurities. One of the objects of the third interlayer insulation film 65 lies, the same as the case of the second embodiment, in relieving stress in the annealing process. Actually, in the case of adopting a construction of the aforementioned film thickness, there occurred no problem up to a temperature of 900 ° C in which stress caused by wrong adhesion resulted.

Fig. 8 is a main sectional view of a semiconductor device that has a ferroelectric capacitor which relates to the embodiment in which the second structure of the present invention is applied to the sixth embodiment. An oxygen-diffusion preventing film 80 contacts with the silicon interface at contacting points 83, 84, 81 and 82 to the source diffusion layer 64 and the drain diffusion layer 65, respectively. This is effective when an annealing process including some oxygen is carried out after a contact hole has been bored.

Fig. 8 is an example of the second structure of the present invention being applied to the sixth embodiment, of course, it is needless to say that this can be applied to the seventh embodiment of the present invention.

With respect to the afore-mentioned ferroelectric formations on a diffusion region or the substrate, the descriptions have been given mainly regarding the nonvolatile memory means, in addition, it is needless to say that they can be applied to other types of memory means (DRAM) which utilize large relative dielectric constant, and also they can be applied to a circuit network which requires high capacitance. Descriptions have been given regarding the ferroelectric film as a material to construct a capacitor. Of course, it is also possible to apply the present invention to a case in which memory means are to be constructed by using $SrTiO_3$, having a large relative dielectric constant, and oxide films having a ferroelectric constant such as $Ta_2O_5$, for these materials require to be subjected to an oxygen annealing process.

APPLICABILITY IN THE INDUSTRY

As described above, the semiconductor device having provided therein a ferroelectric substance relating to the present invention provides formative construction of a ferroelectric substance at the main surface of silicon substrate etc. or on the inside thereof. A ferroelectric substance structure can be formed to such a body having an oxygen-bonding property. A zone or region where a structure having the ferroelectric substance formed may be an intrinsic semiconductor, or an N- or P-type of an impurity diffusion region. According to the present invention, not only on an active zone or a region of an active element, but also on each of the zones or regions of passive elements, such as a resistant diffusion layer, a stopper region, etc. the ferroelectric formative construction can be realized. Typical examples of them are a source region or a drain region of a MIS-type transistor, impurity diffusion regions of the three electrodes of a bipolar transistor, etc. It is, of course, possible to realize a ferroelectric capacitor construction over a diffusion region in a stacked manner, and even in a trench a ferroelectric formative construction can be realized. The semiconductor device according to the present invention is quite suitable to be applied to a nonvolatile memory means of which a highly integrated one has been required.

**Claims**

1. A semiconductor device comprising a ferroelectric film or a high dielectric constant film formed as an elemental component via an electrode on a diffusion layer formed on the principal surface or in the inside of the base of a semiconductor body which has an oxygen bonding property, which is characterized in that;

excepting planes which contact with said diffusion layer and said electrode at least one part on the surface or in the inside of said semiconductor body an oxygen-diffusion preventing film is formed at the lower layer-position than said ferroelectric film or said film having a high dielectric constant.

2. A semiconductor device according to claim 1, which is characterized in that said oxygen-diffusion preventing film is a silicon nitride film, a nitride oxide film or that of mixture of them.

3. A semiconductor device comprising a ferroelectric film or a high dielectric constant film formed as an elemental component via an electrode on a diffusion layer formed on the principal surface or in the inside of the base of a semiconductor body which has an oxygen bonding property, which is characterized in that;

excepting planes which contact with said diffusion layer and said electrode at least one part on the surface or in the inside of said semiconductor body an oxygen-diffusion preventing film is formed at the lower layer-position than said ferroelectric film or said film having a high dielectric constant, and that on said oxygen-diffusion preventing film a stress relieving insulation film the chief ingredient of which is silicon oxide is formed.

4. A semiconductor device according to claim 3, which is characterized in that said oxygen-diffusion preventing film is a silicon nitride film, a nitride silicon oxide film, or that of mixture of them, and said stress relieving insulation film is a silicon oxide film which includes any one of phosphor, boron, gallium and arsenic more than 1 %.

5. A semiconductor device according to any one of claims 1, 2, 3 and 4, which is characterized in that said semiconductor device comprising a ferroelectric film or a high dielectric constant film formed as an elemental component via an electrode on a diffusion layer formed on the principal surface or in the inside of the base of a semiconductor body which has oxygen bonding property, which is characterized in that;

excepting planes which contact with said diffusion layer and said electrode at least one part on the surface or in the inside of said semiconductor body an oxygen-diffusion preventing film is formed at the lower layer-position than said ferroelectric film or said film having high dielectric constant, and that said oxygen-diffusion preventing film contacts with said semiconductor body at a part of a contacting plane where said diffusion layer and said electrode contact with each other.

6. A semiconductor device in which a transistor included as an active element and a capacitor composed of a high dielectric constant film or a ferroelectric film are elemental components and said transistor and said capacitor are connected with each other by a wiring electrode on the principal surface or in the inside of a semiconductor body having oxygen-bonding property, which is characterized in that at least at a part of a region between the principal surface of said semiconductor and an electrode of said capacitor an oxygen-diffusion preventing film is formed.

7. A semiconductor device according to claim 6, which is characterized in that said oxygen-diffusion preventing film is a silicon nitride film, a nitride silicon oxide film or that of mixture of them.

8. A semiconductor device in which a transistor included as an active element and a capacitor composed of a high dielectric constant film or a ferroelectric film are elemental components and said transistor and said capacitor are connected with each other by a wiring electrode on the principal surface or in the inside of a semiconductor body having oxygen-bonding property, which is characterized in that at least at a part of a region between the principal surface of said semiconductor and an electrode of said capacitor an oxygen-diffusion preventing film is formed, and that between said electrode and said oxygen-diffusion preventing film a stress relieving insulation film having silicon oxide as the chief ingredient is formed.

9. A semiconductor device according to claim 8, which is characterized in that said oxygen-diffusion preventing film is a silicon nitride film, a nitride silicon oxide film or that of mixture of them, and said stress relieving insulation film is a silicon oxide film including any of phosphor, boron gallium and arsenic more than 1 %.

10. A semiconductor device in which an active element comprising a transistor and a capacitor element composed of a ferroelectric film or a film having ferroelectric constant are connected with each other by a wiring electrode on the main surface or in the inside of a semiconductor base having oxygen combining property, according to any one of claims 6, 7, 8 and 9, wherein a transistor included as an active element and a capacitor composed of a high dielectric constant film or a ferroelectric film are elemental components and said transistor and said capacitor are connected with each other by a wiring electrode on the principal surface or in the inside of a semiconductor body having oxygen-bonding property, which is characterized in that at least at a part of a region between the principal surface of said semiconductor and an electrode of said capacitor an oxygen-diffusion preventing film is formed, and that at least one part of said oxygen-diffusion preventing film contacts with said semiconductor base at a contact hole bored on the main surface of said semiconductor base.

11. A semiconductor device according to any one of claims 1, 2, 3, 4, 5, 6, 7, 8, 9 and 10, which is characterized in that said ferroelectric film or said high dielectric constant film is PZT, PLZT, $SrTiO_3$ or $Ta_2O_5$. A semiconductor device according to claim 8, which is characterized in that said oxygen-diffusion preventing film is a silicon nitride film, a nitride silicon oxide film or that of mixture of them, and that said stress relieving insulation film is a silicon oxide film including any of phosphor, boron, gallium or arsenic more than 1 %.

Fig. 1

Fig. 2

Tr        C

37

38

3

32    29

33

30

26

21

25    22

24

Fig- 3

Fig. 4

Fig. 5

Fig. 6

Fig. 7

Fig. 8

Fig. 9

Fig. 10

Fig. 11

# INTERNATIONAL SEARCH REPORT

International Application No PCT/JP91/01050

## I. CLASSIFICATION OF SUBJECT MATTER (if several classification symbols apply, indicate all) 6

According to International Patent Classification (IPC) or to both National Classification and IPC

Int. Cl$^5$ H01L27/115

## II. FIELDS SEARCHED

| Minimum Documentation Searched 7 | |
|---|---|
| Classification System | Classification Symbols |
| IPC | H01L27/115, 29/792 |

Documentation Searched other than Minimum Documentation
to the Extent that such Documents are Included in the Fields Searched 8

Jitsuyo Shinan Koho          1970 – 1990
Kokai Jitsuyo Shinan Koho    1972 – 1990

## III. DOCUMENTS CONSIDERED TO BE RELEVANT 9

| Category * | Citation of Document, 11 with Indication, where appropriate, of the relevant passages 12 | Relevant to Claim No. 13 |
|---|---|---|
| Y | JP, A, 1-251760 (Seiko Epson Corp.), October 6, 1989 (06. 10. 89) | 1, 3, 5, 6, 8, 10 |
| A | JP, A, 62-276853 (Hitachi Micro Computer Engineering Co., Ltd.), December 1, 1987 (01. 12. 87), (Family: none) | 3, 4, 8, 9 |
| A | JP, A, 2-290079 (Seiko Epson Corp.), November 29, 1990 (29. 11. 90), Lines 10 to 16, upper right column, page 2 | 1, 2 |
| A | JP, A, 2-186669 (Seiko Epson Corp.), July 20, 1990 (20. 07. 90) | 3, 8 |
| Y | JP, A, 2-183569 (Seiko Epson Corp.), July 18, 1990 (18. 07. 90) | 1, 2, 3, 4, 5, 6, 7, 8, 9, 10 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| October 28, 1991 (28. 10. 91) | November 5, 1991 (05. 11. 91) |
| International Searching Authority | Signature of Authorized Officer |
| Japanese Patent Office | |

**FURTHER INFORMATION CONTINUED FROM THE SECOND SHEET**

**V.☒ OBSERVATIONS WHERE CERTAIN CLAIMS WERE FOUND UNSEARCHABLE** [1]

This international search report has not been established in respect of certain claims under Article 17(2) (a) for the following reasons:

1.☐ Claim numbers        , because they relate to subject matter not required to be searched by this Authority, namely:

2.☐ Claim numbers        , because they relate to parts of the international application that do not comply with the prescribed requirements to such an extent that no meaningful international search can be carried out, specifically:

3.☒ Claim numbers  11  , because they are dependent claims and are not drafted in accordance with the second and third sentences of PCT Rule 6.4(a).

**VI.☐ OBSERVATIONS WHERE UNITY OF INVENTION IS LACKING** [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)